# EUROPÄISCHE PATENTSCHRIFT

(11) **EP 3 574 722 B1**
(45) Veröffentlichungstag und Bekanntmachung des Hinweises auf die Patenterteilung: **09.12.2026**
(21) Anmeldenummer: 18700747.1
(22) Anmeldetag: 16.01.2018
(51) Int. Cl.: H05K 1/02, B29C 64/112, B29C 70/88, H05K 3/12, H05K 3/46, B29K 105/00, B29L 31/34, H05K 1/09, H05K 1/18, H05K 3/00, H05K 3/40

(54) **VERFAHREN ZUR HERSTELLUNG EINES ELEKTRONISCHEN ODER ELEKTRISCHEN SYSTEMS SOWIE NACH DEM VERFAHREN HERGESTELLTES SYSTEM**
METHOD FOR MANUFACTURING AN ELECTRONIC OR ELECTRICAL SYSTEM, AND SYSTEM WHICH IS MANUFACTURED IN ACCORDANCE WITH THE METHOD
PROCÉDÉ DE RÉALISATION D'UN SYSTÈME ÉLECTRONIQUE OU ÉLECTRIQUE ET SYSTÈME RÉALISÉ PAR MISE EN OEUVRE DU PROCÉDÉ

(30) Priorität: 27.01.2017 DE 102017000744
(43) Veröffentlichungstag der Anmeldung: 04.12.2019
(73) Patentinhaber: Friedrich-Alexander-Universität Erlangen-Nürnberg, in Vertretung des Freistaates Bayern, 91058 Erlangen (DE)
(72) Erfinder: GOLD, Gerald, 91054 Erlangen (DE); HELMREICH, Klaus, 90518 Altdorf (DE); HÖRBER, Johannes, 91560 Heilsbronn - Weiterndorf (DE); LOMAKIN, Konstantin, 90411 Nürnberg (DE); SIPPEL, Mark, 90766 Fürth (DE)
(74) Vertreter: Lorenz Seidler Gossel Part. mbB
(86) Internationale Anmeldenummer: PCT/EP2018/051009
(87) Internationale Veröffentlichungsnummer: WO 2018/137972

(56) Entgegenhaltungen:
- DE-U1- 202015 103 801
- US-A1- 2004 196 112
- US-A1- 2007 128 855
- US-A1- 2007 141 743
- US-A1- 2008 143 358
- US-A1- 2009 321 123
- US-A1- 2014 209 372
- US-A1- 2014 231 266
- US-A1- 2015 201 500
- US-A1- 2015 295 300

## Beschreibung

Die vorliegende Erfindung betrifft ein Verfahren zur Herstellung eines elektronischen oder elektrischen Systems.

Aus dem Stand der Technik ist es bekannt, Leiterplatten fotochemisch herzustellen. Dabei wird eine planare Platte, bestehend aus einem dielektrischen Substrat, das ein- oder beidseitig mit Kupferfolien beschichtet ist, so dass elektrisch leitende und elektrisch nicht leitende Lagen entstehen, durch einen fotolithographischen Prozess bearbeitet. Eine dünne Schicht eines lichtempfindlichen Fotolacks wird auf die Oberfläche der metallisierten Platte aufgebracht. Anschließend erfolgt die Belichtung des Fotolacks durch eine Maske mit dem gewünschten Layout der Leiterbahnen der Platte. Je nach der Art des Fotolacks sind entweder die belichteten oder die nicht belichteten Bereiche des Fotolacks in einer Flüssigkeit löslich und werden mittels dieser Flüssigkeit entfernt, so dass Bereiche der Kupferfolie vorliegen, die mit dem Fotolack beschichtet sind und des Weiteren solche Bereiche, für die dies nicht der Fall ist.

Die auf diese Weise vorbehandelte Platte wird sodann in eine Ätzlösung eingebracht. Dabei werden die nicht von dem Fotolack beschichteten Bereiche entfernt, die von dem Fotolack bedeckten Bereiche hingegen nicht, weil der Fotolack beständig gegen die Ätzlösung ist. Auf diese Weise wird ein der Maske entsprechendes Leitungsmuster erhalten.

Durch lagenweises Verkleben der auf diese Weise erzeugten Platten mit zwischengelegten dielektrischen Folien entstehen Leiterplatten mit mehr als zwei leitfähigen Platten bzw. Lagen. Die elektrische Verbindung dieser Lagen erfolgt mittels sogenannter Durchkontaktierungen bzw. vias, wobei es sich um Bohrungen durch die Platten handelt, deren Innenwände in weiteren Prozessschritten metallisiert werden, um eine leitfähige Verbindung herzustellen.

Darüber hinaus sind zur Herstellung von Leiterplatten die Stanztechnik und Drahtlegetechnik sowie die Siebdrucktechnik aus dem Stand der Technik bekannte Verfahren.

Infolge der steigenden Flächendichte von Bauteilanschlüssen muss zur elektrischen Anbindung die Anzahl der Lagen erhöht werden, um fertigungsbedingte Entwurfsregeln für Breite und Abstand einzuhalten. Alternativ müssen blind vias oder buried vias verwendet werden. Bei blind vias handelt es sich um Sacklöcher, die eine Außenlage mit einer Innenlage verbinden, bei buried vias handelt es sich um die Durchkontaktierung zweier Innenlagen, die von den Außenlagen aus nicht sichtbar ist. Sowohl blind vias als auch buried vias stellen Durchkontaktierungen dar, die stets Störstellen im Signalpfad bilden. Hintergrund dafür ist es, dass die hochfrequenztechnischen Eigenschaften außer von den jeweiligen Materialeigenschaften auch von der geometrischen Form der Struktur bzw. des Leitungsquerschnitts abhängen.

Die durch die steigende Flächendichte von Bauteilanschlüssen benötigte hohe Anzahl der erforderlichen elektrischen Verbindungen führt dazu, dass nicht alle Bauteilanschlüsse bzw. nicht alle elektrischen Verbindungen auf dem direkten Weg in ein und derselben Lage verbunden werden können, sondern Lagenwechsel erforderlich werden, d.h. die elektrischen Verbindungen erfahren einen oder mehrere Lagenwechsel.

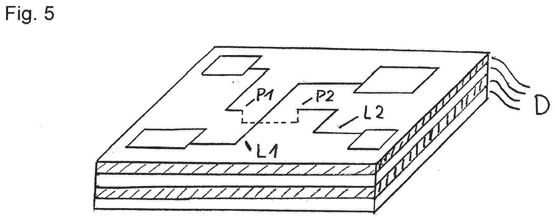

Figur 5 zeigt einen derartigen, aus dem Stand der Technik bekannten Aufbau einer Leiterplatte. Die Bezugszeichen D kennzeichnen die dielektrischen Bereichen, die jeweils beidseitig mit Leiterbahnen versehen sind, die beispielsweise durch das oben erwähnte fotolithographische Verfahren erhalten worden sind. Exemplarisch dargestellt sind zwei Leiterbahnen L1 und L2, wobei die Leiterbahn L1 nur in einer ersten Lage verläuft und die Leiterbahn L2 an den Punkten P1 und P2 einen Lagenwechsel von der ersten in die darunter liegende zweite Lage bzw. umgekehrt durchführt und sich der zwischen den Punkten P1 und P2 befindliche Abschnitt in der zweiten Lage erstreckt.

Nachteilig ist des Weiteren der Übergang von der Leiterplatte mit ihren planaren Lagenstrukturen auf darauf montierte, dreidimensionale Bauteile oder Verbinder zur Anwendungsumgebung. Dies wird im Stand der Technik durch Bond- oder Lötverbindungen realisiert. Diese Vorgehensweise ist für Signale mit gegenwärtig bereits genutzten Frequenzen nicht mehr zufriedenstellend zu realisieren. Abgesehen davon kann durch den eingangs genannten ätztechnischen Fertigungsprozess nicht sichergestellt werden, dass die für hohe Frequenzen erforderlichen geringen Strukturbreiten erreicht werden.

Die gemäß dem Stand der Technik hergestellte Leiterplatte kann erst nach dem letzten Bearbeitungsschritt vor der Bestückung auf ihre spezifizierten Eigenschaften getestet werden. Der Funktionstest der gesamten Schaltung ist erst nach der Bestückung möglich. Bonddrähte werden zur Kontaktierung von ICs ohne Gehäuse verwendet, stellen jedoch eine parasitäre Induktivität und damit eine Störstelle dar. Übersprechen zwischen zwei oder mehreren Übertragungskanälen findet meist an den Bauteilgrenzen statt, da hier die Anschlussstrukturen besonders nahe beieinander liegen. Zudem sind die Anschlussgeometrien und Belegungsmuster vorgegeben und können vom Entwickler hinsichtlich Übersprechen nur begrenzt optimiert werden.

Die Leiterplattenfertigung gemäß dem Stand der Technik erfordert viele Einzelprozessschritte vom strukturierten Substrat zum bestückten Schaltungsträger. Dabei ist jeder Maschinenwechsel (Verpressen der Lagen, Bohren der Durchkontaktierung, Galvanisierung, Bestückung etc.) mit einer neuen Registrierung des Werkstücks und somit mit gewissen Positionsungenauigkeiten verbunden. Ein weiterer Nachteil bekannter Leiterplatten besteht schließlich darin, dass mit der hohen Leistungsdichte eine entsprechend hohe Erwärmung verbunden ist. Um die Wärme abzuführen, müssen zusätzliche Strukturen, wie z.B. thermische Vias oder Kupferscheiben in die Leiterplatte eingebracht werden. Dies kann bei ungünstigen Materialkombinationen und den damit verbundenen unterschiedlichen Wärmeausdehungskoeffizienten zu Rissen und/oder zur Delamination der Lagen der Leiterplatte führen. Die US2004/196112 A1 beschreibt ein bekanntes Beispiel aus dem Stand der Technik.

Der vorliegenden Erfindung liegt die Aufgabe zugrunde, ein Verfahren bereitzustellen, mittels dessen auf vergleichsweise einfache Art und Weise und flexibel elektronische Systeme mit einer gegenüber bekannten System verringerten Anzahl von Störstellen hergestellt werden können. Vorzugsweise liegt der vorliegenden Erfindung die Aufgabe zugrunde, ein Verfahren bereitzustellen, mit dem ein für die Hochfrequenztechnik geeignetes System bzw. eine für die Hochfrequenztechnik geeignete Schaltungsanordnung bereitgestellt werden kann.

Diese Aufgabe wird durch ein Verfahren gemäß Anspruch 1 gelöst. Vorteilhafte Ausgestaltungen sind Gegenstand der Unteransprüche.

Danach ist vorgesehen, dass das Verfahren das lagenfreie Erzeugen wenigstens einer lagenfreien, räumlichen Struktur umfasst, die in der Lage ist, eine oder mehrere elektromagnetische Wellen zu führen. Das Verfahren erfolgt unter Verwendung wenigstens eines additiven Verfahrens bzw. unter Verwendung wenigstens einer nach einem additiven Verfahren arbeitenden Vorrichtung, wobei das lagenfreie Erzeugen der lagenfreien, räumlichen Struktur das gleichzeitige oder sequentielle Auftragen und/oder Abtragen eines oder mehrerer Materialien in räumlicher Anordnung umfasst, wodurch das elektronische oder elektrische System teilweise oder vollständig hergestellt wird.

Die erfindungsgemäß hergestellte Struktur bzw. System ist so ausgebildet bzw. geeignet, dass mittels der Struktur bzw. mittels des Systems elektromagnetische Wellen vorzugweise auf bestimmten Pfaden geführt werden können. Die Erfindung bezieht sich somit nicht auf Strukturen bzw. Systeme, die ausschließlich zur Führung eines elektrischen Stroms ausgeführt sind, sondern auf Strukturen bzw. Systeme, mittels derer ausschließlich oder zumindest auch elektromagnetische Wellen vorzugsweise zielgerichtet geführt werden können, was nicht ausschließt, dass zusätzlich Ladungsträger geführt werden, d.h. z.B. ein Stromfluss möglich ist.

Ein bevorzugtes Anwendungsgebiet der vorliegenden Erfindung ist die Hochfrequenztechnik und/oder Systeme für Datenraten.

Bei dem oder den Materialien kann es sich beispielswiese um elektrisch leitende und/oder elektrisch nicht leitende Materialien und/oder Materialien mit besonderen magnetischen und/oder elektrischen Eigenschaften handeln.

Vorzugsweise erfolgt die Herstellung der Struktur in beliebiger räumlicher Anordnung.

Das elektronische oder elektrische System kann einen Schaltungsträger aufweisen oder aus diesem bestehen.

Unter dem Begriff "lagenfrei" und unter dem Begriff "in räumlicher Anordnung" ist zu verstehen, dass die räumliche Struktur nicht zwingend Lage für Lage hergestellt wird d.h. zweidimensional, wenngleich auch dies möglich wäre, sondern lagenunabhängig. In anderen Worten wird nicht zunächst eine Lage hergestellt, dann die nächste etc., die dann miteinander verbunden werden, sondern es erfolgt der Aufbau einer räumlichen, d.h. dreidimensionalen Struktur.

Durch das erfindungsgemäße Verfahren ist es möglich, funktionsorientierte leitende oder nicht leitende räumliche Strukturen mit weitgehend beliebigen, insbesondere im Hinblick auf die Leistungsfähigkeit der Fertigungseinrichtung optimierten Querschnittsgeometrien, ggf. auf einem beliebig geformten und gearteten Träger für elektrische und/oder elektronische Schaltungen vor, während oder nach dem Aufbringen von Bauteilen durch gleichzeitiges oder sequentielles Auftragen und/oder Abtragen von leitenden oder nicht leitenden Materialien und/oder sonstige Materialien in beliebiger räumlicher Anordnung herzustellen. Statt einer streng lagenweise Vorgehensweise wird erfindungsgemäß wenigstens bereichsweise dreidimensional Material aufgebaut und nicht nur in einer Fläche, d.h. zweidimensional.

Wird ein Träger als Substrat verwendet, kann dieser in einer Ebene liegend oder dreidimensional ausgebildet sein.

Bei dem oder den additiven Verfahren kann es sich um ein Druckverfahren bzw. 3D-Druckverfahren, insbesondere um ein Inkjet-, Plasmadust-, Aerosol-Jet- oder um ein Extrusionsverfahren oder um ein Laserschmelzverfahren handeln. Von der Erfindung sind auch beliebige andere additive Verfahren, wie z.B. das "Fused Deposition Molding" (FDM) umfasst. Auch können zur Herstellung eines Systems mehrere unterschiedliche additive Verfahren zur Anwendung kommen. Bzgl. des Aerosol-Jet-Verfahrens wird auf die US 8,640,975 verwiesen, die ein solches Verfahren bzw. ein Miniatur Aerosol-Jet-Verfahren beschreibt, das ebenfalls im Rahmen der vorliegenden Erfindung zur Anwendung kommen kann.

In einer bevorzugten Ausgestaltung der Erfindung werden mittels des Verfahrens eine oder mehrere wellenwiderstandsrichtige Leitungen und/oder Leiterzüge und/oder vorzugsweise passive Bauelemente, insbesondere Filter und/oder Koppler und/oder Antennen und/oder dielektrische und/oder elektrisch leitfähige Bereichen aufgebaut. Diese Bereiche können in einer wechselnden oder anderweitigen Abfolge aufgebaut werden.

Das Verfahren kann weiterhin die Bereitstellung oder Fertigung wenigstens eines Trägers umfassen sowie das lagenfreie Erzeugen der wenigstens einen räumlichen Struktur auf dem Träger. So ist es beispielsweise denkbar, dass auf einen beliebig geformten und gearteten Träger durch eine geeignete Abfolge von dielektrischen und leitfähigen Bereichen wellenwiderstandsrichtige Leitungen, Leiterzüge sowie vorzugsweise passive Bauelemente aufgebaut werden. Dabei kann es sich beispielsweise um Filter, Koppler, Antennen etc. handeln.

Bei dem Träger kann es sich beispielsweise auch um einen Schaltungsträger handeln, wie er aus dem Stand der Technik beispielsweise gemäß Figur 5 bekannt ist.

Der Träger kann aus Kunststoff, Metall (z.B. Aluminium) oder Keramik bestehen oder diese Materialien aufweisen. Er kann bereits mit Bauelementen und/oder Leiterbahnen bestückt oder auch nicht bestückt sein.

An dieser Stelle wird darauf hingewiesen, dass der Begriff "leitend" wenn nicht anders angegeben "elektrisch leitend" bedeutet.

Des Weiteren wird darauf hingewiesen, dass die Begriffe "ein" und "eine" nicht zwingend auf genau eines der fraglichen Elemente verweisen, wenngleich auch dies von der Erfindung umfasst ist, sondern auch eine Mehrzahl der fraglichen Elemente mit umfassen. Ebenso ist darauf hinzuweisen, dass die Verwendung der Mehrzahl eines Elementes auch das Vorhandensein von nur genau einem Element mit einschließt und umgekehrt die Verwendung des Singulars bzgl. des Elementes auch eine Mehrzahl dieser Elemente mit umfasst.

Der Träger kann elektrisch nichtleitend, elektrisch leitend oder hinsichtlich der elektrischen Leitfähigkeit hybrid, d.h. bereichsweise leitend und bereichsweise nicht leitend aufgebaut sein. Er kann beispielsweise aus einem Schaltungsträger, wie einer Leiterplatte oder aus einem MID (Molded Interconnected Device) bestehen oder diesen/dieses aufweisen.

Der Träger kann ebenfalls nach dem erfindungsgemäßen Verfahren oder auch nach einem anderen Verfahren hergestellt sein bzw. werden.

Der Träger kann eine oder mehrere elektrische und/oder mechanische und/oder thermische Funktionalitäten aufweisen bzw. bereitstellen. Durch geeignete Materialien oder Strukturen kann beispielsweise die Erwärmung der aufzubauenden Schaltung und/oder die Wärmeabfuhr aus dieser gewährleistet werden.

Der Träger kann nur eine mechanische Funktion ausüben, indem er das Substrat, d.h. die Grundlage für das System bildet. Er kann alternativ oder zusätzlich elektrische Funktionsstrukturen, wie z.B. Antennen, Verbinder, Resonatoren, Masseflächen etc. beinhalten. Er kann auch zur Aufnahme von Bauteilen, wie ICs dienen, die vor der Herstellung der Verbindungsstrukturen, wie Leitungen etc. auf dem Träger oder in Kavitäten des Trägers platziert werden.

In einer besonders bevorzugten Ausgestaltung der Erfindung wird durch das Verfahren wenigstens eine querschnittserhaltende, d.h. wellenwiderstandsrichtige Leitung, insbesondere Signalleitung dadurch hergestellt, dass zunächst ein elektrisch leitender Bereich hergestellt wird, auf diesem ein dielektrischer Bereich aufgetragen wird, auf dem wiederum ein oder mehrere Leiterzüge erzeugt werden, ein weiterer dielektrischer Bereich aufgebracht wird, so dass der oder die Leiterzüge von einer dielektrischen Ummantelung umgeben sind und anschließend eine weitere Ummantelung aufgebracht wird, die wenigstens teilweise metallisiert ist oder wird oder in anderer Weise leitfähig ist und/oder aus einem Dielektrikum besteht. Zur Herstellung solcher Leitungen wird vorzugsweise das Aerosol-Jet-Verfahren angewandt. Es kommen jedoch auch andere additive Verfahren in Betracht, mit denen dielektrische und leitfähige Bereiche erzeugt werden können.

Die Signalleitung kann eine Innenleitung und eine Außenleitung aufweisen. Die Signalleitung kann den oben genannten Aufbau oder auch einen davon abweichenden Aufbau haben.

Denkbar ist es auch, dass eine querschnittserhaltende, d.h. wellenwiderstandsrichtige Leitung, insbesondere Signalleitung dadurch hergestellt wird, dass ein dielektrischer Bereich hergestellt wird, in dem sich kein oder wenigstens ein Leiterzug befindet, und eine den dielektrischen Bereich umgebende Ummantelung aufgebracht wird, die wenigstens teilweise metallisiert ist oder wird und/oder aus einem Dielektrikum besteht, wobei die vorgenannten Schritte teilweise oder alle gleichzeitig oder nacheinander durchgeführt werden.

Grundsätzlich kann die Herstellung der Leitungen sequentiell (ein Material nach dem anderen wird aufgetragen), durch Ausbildung von aneinander gesetzten scheibenartigen Bereichen, oder auch simultan erfolgen, indem die unterschiedlichen Materialien gleichzeitig aufgebracht werden.

Mit dem erfindungsgemäßen Verfahren können beliebige Bauelemente, wie z.B. Stecker, Buchsen, Halterungen etc. hergestellt werden. Auch Koppler, Antennen, wie z.B. Helixantennen, Hornantennen etc. können mit dem erfindungsgemäßen Verfahren hergestellt werden.

Vorzugsweise ist vorgesehen, dass die dielektrische Ummantelung in einer Breite aufgebracht wird, die der Gesamtbreite der Leitung entspricht und/oder dass die dielektrische Ummantelung so aufgebracht wird, dass deren Abstand zu dem elektrisch leitenden Bereich zu den Rändern des Leitungsquerschnitts der Leitung hin abnimmt. Dies wird durch die selektive Aufbringung des Dielektrikums ermöglicht.

Weiter ist von Vorteil, wenn die wenigstens teilweise metallisierte Ummantelung mit dem elektrisch leitenden Bereich verbunden wird, so dass ein in der Querschnittsansicht vollständig geschlossener leitfähiger Mantel der Leitung bzw. der Signalleitung gebildet wird.

Durch das beschriebene Verfahren können alle Leitungsquerschnittstypen äquivalent zu den üblichen Formen wie Streifenleitung, Koplanarleitung, differentielle Leitung etc. erzeugt werden.

Denkbar ist es, dass je nach Beschaffenheit des Trägers bzw. der darunter liegenden Strukturen eine dielektrische Schicht als Auflage der Leitung vorliegt, um eine bessere Adhäsion zu erzielen oder Unebenheiten auszugleichen.

Vorzugsweise weist die Leitung einen längshomogenen Leitungsquerschnitt auf, d.h. ändert den Querschnitt über die Länge nicht. Abweichend davon kann die Leitung bzw. deren Ummantelung an der Ober- oder Unterseite an bestimmten Stellen durchbrochen sein, um z.B. eine elektrische Kopplung zum Träger, anderen Leitungen oder Bauteilen zu erreichen und Verzweigungsstellen zu bilden.

Weiter ist es möglich, dass die Abstände der Leiterzüge im Inneren der Leitung zueinander für sich oder zusammen mit dem Abstand zur äußeren Metallisierung der Ummantelung so gewählt werden, dass diejenigen Abstände, die mit dem verwendeten Prozess unter den geringsten Toleranzen herstellbar sind, eben die sind, die den Leitungswellenwiderstand am wesentlichsten beeinflussen.

Erfindungsgemäß ist es möglich, eine flache (Höhe < Breite) Leitung bzw. Signalleitung zu erzeugen.

Insbesondere (aber nicht ausschließlich) eine solche flache Bauform erlaubt Überkreuzungen ohne zusätzliche Stützstrukturen. Auch eine solche Überkreuzung ist von der Erfindung mit umfasst. Dabei bleibt die Querschnittsgeometrie der Leitungen vorzugsweise unverändert, d.h. nimmt auch im Kreuzungsbereich keine Änderung an. Somit entstehen keine Störstellen, d.h. keine Reflexion im Signalpfad. Während gemäß dem Stand der Technik aufgrund der lagenweisen Anordnung ein Lagenwechsel der Leitung sowie Durchkontaktierungen mit von der Leitung abweichenden Querschnitten im Bereich der Kreuzung der Leitungen notwendig ist - wie aus Figur 5 ersichtlich - entfallen diese Erfordernisse erfindungsgemäß, da nicht mehr streng lagenweise gearbeitet wird. Denkbar ist es beispielsweise zunächst einen ersten Leiter zu fertigen und anschließend einen zweiten Leiter zu fertigen, der den ersten Leiter überkreuzt, was voraussetzt, dass dreidimensional gearbeitet wird, da der zweite Leiter im Kreuzungsbereich über den ersten Leiter gelegt werden muss. In der vorteilhaften Ausführungsform der Leiter ist dies übersprecharm möglich.

Grundsätzlich können die Leitungen beliebig verlaufen, parallel, über Kreuz in beliebigen Winkeln, in unterschiedlichen Ebenen, in unterschiedlichen Raumrichtungen etc., ohne sich gegenseitig zu beeinflussen.

Aufgrund der Flexibilität des Verfahrens können beliebige Leitungsbestandteile an beliebig ausgewählte Kontaktstellen der Bauteile angebunden werden.

Vorzugsweise weist die erfindungsgemäße Struktur keinerlei Durchkontaktierungen oder Bohrungen auf, da deren Vorhandensein nicht zwingend erforderlich ist. So können Störstellen verhindert werden.

Um größere Höhenunterschiede zu überwinden, kann zusätzlich Material aufgebracht werden. Dabei können Hohlräume komplett mit Material gefüllt werden. Auch ist es denkbar, dass in dem Material eine Negativform, d.h. ein hohler Bereich gebildet wird, der dann mit einem anderen Material gefüllt wird. Vorzugsweise erfolgt diese Füllung mit einem leitfähigen Material. Auf diese Weise kann ein Leiter gebildet werden, der im Verhältnis zur Leitung bzw. Signalleitung einen größeren Querschnitt aufweist, so dass dieser Leiter mit hoher Stromtragefähigkeit beispielsweise zur Stromversorgung bzw. Leistungsversorgung genutzt werden kann.

Anstelle oder zusätzlich zu dem leitenden Material können auch thermisch leitfähige oder wärmetransportierende feste, flüssige, gasförmige Materialien in den Hohlraum eingebracht werden, so dass eine Wärmeabfuhr aus dem System möglich ist. So kann Wärme beispielsweise zwischen dem hergestellten System und einem Kühlkörper oder einem Träger ausgetauscht werden.

Sowohl die elektrischen Leitungen als auch die Entwärmungsstrukturen können dabei nicht nur horizontal oder vertikal, sondern in beliebige Raumrichtungen geführt werden. Dies gilt für die hergestellten Leitungen bzw. Signalleitungen entsprechend.

Vorzugsweise ist vorgesehen, dass das Verfahren im Rahmen der mechanischen und/oder elektrischen Integration von Bauteilen außer dem additiven Verfahren keinerlei zusätzlichen Prozessschritt aufweist, wie etwa Löten oder Bonden.

Zur elektrischen Kontaktierung über Bauteilgrenzen hinweg kann es vorkommen, dass Spalte oder Höhenunterschiede überwunden werden müssen. Spalte können z.B. durch ein dielektrisches Material gefüllt werden und Höhenunterschiede z.B. mittels des dielektrischen Materials beispielsweise in Form von Rampen oder sonstigen Erhebungen ausgeglichen werden. Auf dem auf diese Weise aufgebrachten dielektrischen Material können dann eine oder mehrere Leitungen, wie Signalleitungen etc. erzeugt werden.

Vorzugsweise werden die Leitungen, insbesondere Signalleitungen geodätisch erzeugt, d.h. auf dem kürzesten Weg zwischen zwei Anschlusspunkten.

In einer weiteren Ausführungsform ist es denkbar, dass die mechanische Integration von Bauteilen jeglicher Art durch eine Befestigung an einem Träger, durch Einbetten in das dielektrische Material vor dessen Aushärtung, durch das Überdrucken des Bauteils oder durch das Überdecken von Leitungen, insbesondere Signalleitungen erfolgt.

Weiterhin kann vorgesehen sein, dass die elektrische Verbindung einer Leitung, insbesondere einer Signalleitung mit einem Bauteil durch die Kontaktierung der metallischen Ummantelung der Leitung mit dem Gehäuse des Bauteils oder mit einem Masseanschluss des Bauteils sowie die Kontakierung des Signalleiters an dem Signalanschluss erfolgt. Auf diese Weise kann jede Leitung bzw. Signalleitung wellenwiderstandsrichtig bis zu den jeweiligen Bauteilgrenzen geführt werden. An der Bauteilgrenze können so durch die erfindungsgemäßen additiven Verfahren an den Bauteilen impedanzangepasste Übergänge erzeugt werden. Dabei kann die leitfähige Ummantelung der Leitung genutzt werden, um Anschlusspins gegeneinander abzuschirmen, so dass ein Übersprechen selbst an Bauteilanschlüssen minimal wird.

Durch das vorliegende Verfahren sind beliebige elektrische und elektronische Elemente, wie Leitungen oder Bauteile herstellbar. So können nach dem Verfahren passive Bauelemente und/oder Wellenleiter, insbesondere Hohlleiter und dielektrische Wellenleiter, wie Lichtwellenleiter hergestellt werden. Bei einem dielektrischen Wellenleiter ist lediglich an entsprechenden Stellen ein Dielektrikum mit einer relativen Permittivität zu verwenden, welche sich von der des umgebenden Dielektrikums unterscheidet. Durch Aufbringen einer metallischen Schicht können diese auch gegeneinander geschirmt werden.

Weiterhin kann vorgesehen sein, dass durch das additive Verfahren und/oder durch ein selektive Sinterverfahen eine ortsabhängige Leitfähigkeit und/oder Materialeigenschaft des Trägers und/oder des Systems hergestellt wird. So kann an verschiedenen Stellen eine ortsabhängige, d.h. ortsvariable Leitfähigkeit oder andere Materialeigenschaft erzeugt werden. Somit werden graduelle Übergänge der Leitfähigkeit erreicht. Diese können sodann als mit herkömmlichen Techniken nicht zu verwirklichende Schaltungselemente eingesetzt werden, beispielsweise um reflexionsarme Abschlusswiderstände zu schaffen. Ebenso können damit neuartige Koppler aufgebaut werden, indem Bereiche unterschiedlicher Leitfähigkeit als ortsunabhängige Kopplung genutzt werden.

Von der Erfindung ist der Fall umfasst, dass die Herstellung des Systems mit genau einem additiven Verfahren durchgeführt wird. Jedoch ist auch der Einsatz mehrerer unterschiedlicher additiver Verfahren denkbar, die ggf. unterschiedliche Auftragsdicken des aufgebrachten Materials erzeugen. So ist es beispielsweise denkbar, für feine Strukturen, wie Leiter z.B. das Aerosol-Jet-Verfahren einzusetzen. Unterstützend können stärker auftragende Verfahren eingesetzt werden, wie z.B. das Fused Deposition Molding (FDM). Dieses Verfahren kann beispielsweise angewandt werden, um den Träger herzustellen, um die Trägergeometrie zu verändern, die Gesamtbauhöhe des Systems zu erhöhen, Stützstrukturen aufzubauen oder andere Funktionsstrukturen zu integrieren.

Auch der Einsatz anderer Bearbeitungswerkzeuge ist denkbar und von der Erfindung mitumfasst. Beispiele sind das Lasern oder Fräsen, um ablativ Funktionsstrukturen zu schaffen. Ablative Verfahren können darüber hinaus eingesetzt werden, bereits hergestellte Elemente, wie z.B. Signalleitungen oder bereits kontaktierte Bauelemente von der Gesamtschaltung, d.h. von dem System wieder zu trennen bzw. zu entfernen, z.B. zur Ermöglichung einer Funktionsprüfung oder wenn die Funktionsprüfung nicht bestanden wurde.

Das erfindungsgemäße Verfahren kommt vorzugsweise mit wesentlich weniger Produktionsschritten aus, als dies nach dem Stand der Technik bekannt ist. Vorzugsweise werden in genau einer Produktionsmaschine dielektrische und leitfähige Bereiche additiv erzeugt und Bauteile bestückt und angeschlossen. Maschinenwechsel und die damit verbundenen zusätzlichen Toleranzen der Registrierung entfallen. Abgesehen davon reduzieren sich die dem fotolithographischen Prozess inhärenten Herstellungskosten, wie Material-, Rüst-, Logistik-, Maschinen- und Lagerkosten. Die Maschinenkosten des erfindungsgemäßen Verfahrens liegen deutlich unter denen einer üblichen Leiterplattenfertigung.

Das erfindungsgemäße Verfahren ist resourcenschonend, da nur dort Material aufgetragen wird, wo es für die spätere Funktion des Systems benötigt wird. Anders als bei dem derzeit angewandten Verfahren der fotolithographischen Fertigung entfallen Galvanikprozesse und es fällt kein Materialabfall in Form von überschüssigen Kupferflächen an.

Der im Vergleich wesentlich geringere Durchsatz der einzelnen Maschine wird dadurch kompensiert bzw. überkompensiert, dass Maschinenwechsel, d.h. Transportzeit, Zwischenlagerzeit und Rüstzeit eingespart werden. Außerdem kann der Durchsatz durch Parallelisieren gleichartiger Maschinen skaliert werden, was nicht nur den Vorteil birgt, keinen Engpass im Materialfluss zu besitzen, sondern auch, dass Maschinen und Erzeugnisse in Prototypen- und Serienfertigung identisch sind. Dadurch sinken die Kosten für Prototypen und es werden erhebliche Entwicklungs-, Fertigungsüberführungs- und Testzeiten eingespart und damit Produkteinführungszeiten reduziert. Ein weiterer einzigartiger Vorteil ist die zeitlich und mengenmäßig nahezu frei gestaltbare Steigerung des Produktionsvolumens bei Markteinführung eines neuen Produkts und die damit einhergehende Minimierung des sonst enormen wirtschaftlichen Risikos in dieser Phase.

Vorteilhaft ist es, wenn das Verfahren wenigstens teilweise sequentiell durchgeführt wird und wenn während des Verfahrens wenigstens ein Funktionstest an wenigstens einem Element des elektronischen Systems erfolgt.

Der vollständig oder wenigstens teilweise sequentielle Aufbau der Verbindungsstrukturen ermöglicht einen Funktionstest jedes hergestellten oder platzierten Schaltungselementes bzw. Bauteils zu jedem Zeitpunkt des Herstellungsprozesses. Wird eine Möglichkeit vorgesehen, die elektrischen Istgrößen wie z.B. Leitungswellenwiderstand oder Filterflankenposition während der Fertigung zu messen, können daraus Stellgrößen für die Produktionsanlage berechnet werden, wodurch sich eine Regelung funktionsentscheidender Parameter und mithin ein völlig neues Qualitätsniveau realisieren lässt. In ähnlicher Weise können Stellgrößen durch fertigungsparallele Simulation bereitgestellt werden. Gleichzeitig sinken die Gesamtkosten, da die nachgelagerte Qualitätssicherung der so produzierten Schaltungsträger entfällt. Schlägt ein Funktionstest einer Signalleitung oder eines Bauteils während der Fertigung fehl, so kann eine neue Signalleitung als Ersatz zusätzlich erzeugt werden, ohne dass die Gesamtschaltung bzw. der gesamte Schaltungsträger aussortiert und verworfen werden müsste. Ebenso können als fehlerhaft getestete Bauteile oder ICs in dem Schaltungsträger verbleiben und überdruckt werden. Sieht man zusätzliche Bearbeitungsmöglichkeiten wie einen Fräskopf oder Laser vor, können bestehende Verbindungen aufgetrennt und neue Ersatzstrukturen ergänzt werden.

All diese Maßnahmen sind während des Fertigungsprozesses des Systems bzw. des Schaltungsträgers möglich und nicht nach Abschluss der Fertigung, was mit den vorgenannten Vorteilen verbunden ist und ein frühzeitiges Eingreifen ermöglicht.

Das selektive Entfernen, Hinzufügen oder Ersetzen von Bauteilen oder Leitungen sowie das ablative oder additve Modifizieren von Funktionsstrukturen kann vor, während oder nach der Funktionsprüfung, insbesondere nach der Feststellung einer Fehlfunktion erfolgen.

Vorzugsweise ist vorgesehen, dass die Verbindung einer Leitung mit einem Bauteil mit denselben Schritten bzw. mit demselben Herstellungsverfahren erfolgt wie die Herstellung der Leitung selbst. Dabei treten wesentlich geringere Störstellen im Signalpfad auf als bei herkömmlichen Technologien wie Löten oder Bonden, von denen dabei vorzugsweise keinerlei Gebrauch gemacht wird. Durch den Ersatz dieser separaten Herstellungsschritte entfallen auch deren Produktionszeiten und - kosten.

Störendes elektrisches Übersprechen kann erheblich reduziert werden, indem eine leitfähige Ummantelung an den entsprechenden Bauteilanschlüssen bzw. Kontaktflächen erzeugt wird. Bei herkömmlichen Schaltungsträgern kann Übersprechen nur im Schaltungsträger selbst, nicht jedoch direkt an Bauteilanschlüssen beeinflusst werden.

Die Bauteile, Leitungen etc. können geometrisch beliebig platziert werden und dadurch auch nach mechanischen oder thermischen Aspekten ausgerichtet werden. Sie können vollständig eingebettet werden, so dass Signalleitungen ober- bzw. unterhalb der Bauteile geführt werden können, wodurch die Integrationsdichte erheblich steigt. Außerdem wird dadurch ein zusätzlicher Prozessschritt zum Vergießen der Bauteile überflüssig.

Zusätzlich ist es mit dem erfindungsgemäßen Herstellungsverfahren möglich, Bauteile vor, während oder nach dem Herstellungsprozess zu bestücken und zu kontaktieren. Dies ermöglicht zunächst, kritische Schaltungsteile aufzubauen und zu testen und nur bei bestandenem Funktionstest der Teilschaltung den Herstellungsprozess fortzuführen. Speziell bei ICs kann somit auf wesentlich kostengünstigere, nicht getestete bare dies zurückgegriffen werden. Diese werden mit Anschlussstrukturen versehen, die zur späteren Funktion der Schaltung ohnehin benötigt werden, getestet und nur bei erfolgreichem Test mit anderen ICs oder Schaltungsteilen verbunden.

Durch das erfindungsgemäße drucktechnische Verfahren kann der Querschnitt der wellenwiderstandsrichtigen Signalleitung so angepasst werden, dass der Leitungswellenwiderstand möglichst unsensibel auf Toleranzen im Fertigungsprozess reagiert. Darüber hinaus ist der entscheidende Vorteil gegenüber Mehrlagenleiterplatten, dass Leiterzüge nicht abschnittsweise in Signallagen zwischen signalübergreifenden Bezugspotentiallagen verlegt werden müssen. Stattdessen kann jede Leitung mit jeweils eigener Bezugspotentialstruktur auf möglichst direktem Weg verlegt werden, ohne dabei den Querschnitt und damit den Leitungswellenwiderstand zu ändern.

Die Entflechtung komplexer Schaltungen wird anstatt durch signalbeeinträchtigenden Lagenwechsel zwischen mehreren Lagen durch Überkreuzungen von gegeneinander isolierten und geschirmten Signalleitungen gelöst. Da jede Signalleitung sehr flach sein kann und durch das Fertigungsverfahren eine günstige Form besitzt, ist eine Kreuzung von Leitungen ohne zusätzliche Stütz oder Brückenstrukturen möglich. Durch die abschirmende Ummantelung ist geringes Übersprechen benachbarter Signalleitungen inhärent. Vorgegebene Signallaufzeiten können durch entsprechend lange Signalleitungen dieser Form oder durch Materialien unterschiedlicher Permittivität erreicht werden.

Das durch das Verfahren gemäß der Erfindung erhaltene System bzw. der Schaltungsträger erlaubt es, durch einfach herzustellende, wellenwiderstandsrichtige Verbindungsleitungen und Übergänge zu Bauteilen einen insgesamt reflexionsarmen Signalpfad zu realisieren. Die Gesamtdämpfung ist abhängig von Leiterlänge, verwendeten Materialien und herstellungsspezifischer Oberflächenrauhigkeit, wobei der Vorteil geringerer Reflexion für typische Leitungslängen überwiegt.

Darüber hinaus können passive Bauteile, die mit herkömmlicher Technologie nicht verwirklicht werden können, wie reflexionsarme Abschlusswiderstände oder Koppler mit ortsabhängigen Kopplungsfaktoren durch Gradienten der Materialeigenschaften z.B. der Leitfähigkeit erzeugt werden.

Die neue Topologie erfordert einen weniger komplexen Entwurfsprozess, da die Information über die zu verbindenden Anschlüsse ausreicht, um die Schaltung herzustellen. Die Notwendigkeit, durch den herkömmlichen, lagenorientierten Aufbau erzwungene, die Signalintegrität beeinträchtigende Wegführung der einzelnen Leiterzüge zu finden (routing), entfällt. Somit ist es möglich, den Entwurfsprozess stärker auf andere wesentliche Aspekte zu richten. Dazu gehören beispielsweise die Bauteilplatzierung, die Entwärmung, EMV etc., wodurch optimierte Schaltungen hoher Integrationsdichte ermöglicht werden.

Des weiteren können Anschlussflächen aufgedruckt werden oder größere Erhebungen metallisiert werden, die z.B. als Kontaktstruktur zu anderen Schaltungsträgern oder Bauteilen fungieren.

An dieser Stelle wird darauf hingewiesen, dass die Begriff "Bauteil" und "Bauelement" synoym für dieselben Elemente verwendet werden.

Der Begriff "Bereich" kann eine Schicht, d.h. ein zweidimensionales Gebilde betreffen oder auch eine dreidimensionale Struktur.

Die vorliegende Erfindung betrifft des Weiteren ein elektronisches oder elektrisches System, das nach einem Verfahren gemäß einem der Ansprüche 1 bis 14 hergestellt ist.

Vorteilhafte Eigenschaften des Systems bzw. der Struktur sind auch die Merkmale der Ansprüche 1 bis 14, soweit sie sich auf das System bzw. die Struktur beziehen.

Bei dem System bzw. bei der Struktur handelt es sich beispielsweise um einen Schaltungsträger, allerdings ist die Erfindung nicht darauf beschränkt.

Wie oben ausgeführt, ist die erfindungsgemäß hergestellte Struktur bzw. System ist so ausgebildet, dass mittels der Struktur bzw. mittels des Systems elektromagnetische Wellen vorzugsweise auf bestimmten Pfaden geführt werden können. Die Erfindung bezieht sich somit nicht auf Strukturen bzw. Systeme, die ausschließlich zur Führung eines elektrischen Stroms ausgeführt sind, sondern auf Strukturen bzw. Systeme, mittels derer ausschließlich oder zumindest auch elektromagnetische Wellen vorzugsweise zielgerichtet geführt werden können, was nicht ausschließt, dass zusätzlich Ladungsträger geführt werden, d.h. z.B. ein Stromfluss möglich ist.

Die erfindungsgemäße Struktur bzw. das erfindungsgemäße System findet vorzugsweise in der Hochfrequenztechnik Anwendung.

Vorteilhaft ist es, wenn das System wenigstens eine querschnittserhaltende, d.h. wellenwiderstandsrichtige Leitung, insbesondere Signalleitung aufweist, die zumindest einen elektrisch leitenden Bereich, zumindest einen auf diesem angeordneten dielektrischen Bereich, in der ein oder mehrere Leiterzüge eingebettet sind und wenigstens eine Ummantelung aufweist, die wenigstens teilweise metallisiert ist, wie dies oben näher ausgeführt ist.

Dabei ist vorzugsweise vorgesehen, dass der Mantel der Leitung mit dem elektrisch leitenden Bereich verbunden ist, so dass eine geschlossene Ummantelung vorliegt.

Auch kann das System wenigstens eine querschnittserhaltende, d.h. wellenwiderstandsrichtige Leitung, insbesondere Signalleitung aufweisen, die einen dielektrischen Bereich, keinen oder wenigstens einen darin befindlichen Leiterzug und wenigstens eine Ummantelung aufweist, die wenigstens teilweise metallisiert ist.

Denkbar ist es, dass mehrere der Leitungen übereinander verlaufen, so dass ein oder mehrere Kreuzungsbereiche entstehen, wobei vorzugsweise auch im Kreuzungspunkt eine in Längsrichtung der Leiter konstanter Leitungsquerschnitt vorliegt, d.h. es ergeben sich durch die Überkreuzung keine Querschnittsänderungen. Das System kann ein oder mehrere Bauteile, wie Antennen, Verbinder, Resonatoren, die räumlich ausgedehnt sein können, aufweisen, die durch das additive Verfahren elektrisch und/oder mechanisch integriert sind.

**In** einer weiteren Ausführungsform ist vorgesehen, dass das System wenigstens einen Träger aufweist, wobei vorzugsweise vorgesehen ist, dass der Träger eine oder mehrere elektrische und/oder mechanische und/oder thermische Funktionalitäten aufweist, was mit den oben genannten Vorteilen verbunden ist.

Durch Nutzung der mit dem Verfahren gemäß der Erfindung entstandenen Freiheitsgrade und/oder durch das gezielte Erzeugen ortsabhängig verschiedener Materialzusammensetzungen oder -dichten können bestimmte Funktionen, insbesondere durch ortsabhängige elektrische Eigenschaften, verwirklicht oder herkömmliche Bauteile oder deren Anbindung hinsichtlich elektrischer, mechanischer oder thermischer Eigenschaften optimiert oder substituiert werden (Leitfähigkeitsgradient, Wellensumpf, ortsabhängiger Koppelfaktor, Koppler etc.). Durch das Erzeugen oder Aufbringen von Strukturen oder Bauteilen beliebiger Form aus Materialien geeigneter Wärmeleitfähigkeit oder Wärmekapazität kann eine optimierte Entwärmung oder Erwärmung von Bauteilen oder Funktionsstrukturen erreicht werden (coins, Kühlkörper, heat pipes, Dämmung etc.).

Wie oben ausgeführt, können leitfähige Strukturen ausreichender Abmessungen insbesondere für hohe Stromtragfähigkeit oder dielektrische Strukturen ausreichender Abmessungen insbesondere zur Reduktion der Gefahr von Überschlägen erzeugt werden.

Weitere Einzelheiten und Vorteile der Erfindung werden anhand eines in der Zeichnung dargestellten Ausführungsbeispiels näher erläutert.

Es zeigen:
- Figur 1:: eine schematische Querschnittsansicht durch eine gemäß der Erfindung hergestellte Signalleitung,
- Figur 2:: eine schematische Schnittansicht durch zwei überkreuz liegende, gemäß der Erfindung hergestellte Signalleitungen sowie deren perspektivische Ansicht im Kreuzungsbereich,
- Figur 3:: eine schematische Schnittdarstellung gekreuzter Signalleitungen mit zusätzlich aufgefüllten Zwischenräumen,
- Figur 4:: schematische Schnittansichten von integrierten Bauteilen mit Dielektrikum zum Ausgleich der Höhenunterschiede und eine perspektivische Ansicht der Anbindung der Leitung an Bauteilanschlüsse,
- Figur 5:: eine schematische perspektivische Ansicht einer Leiterplatte gemäß dem Stand der Technik.

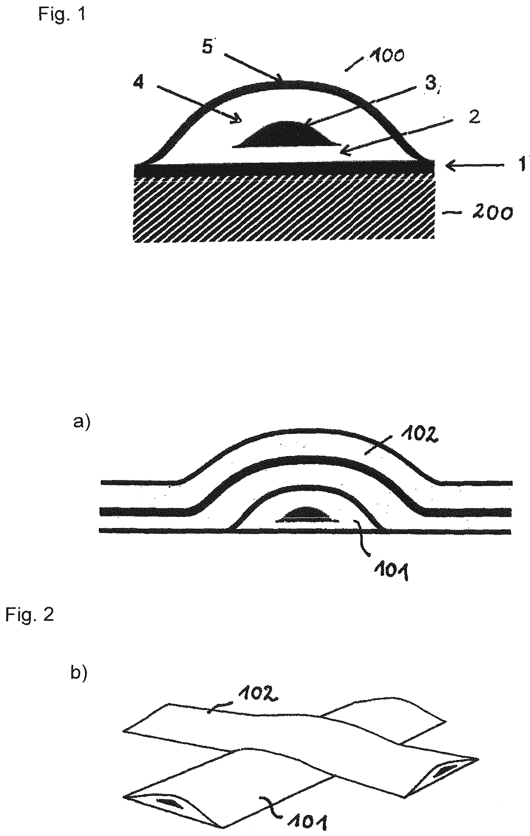

Figur 1 zeigt mit dem Bezugszeichen 1 eine elektrisch leitende Schicht, die der Breite der Signalleitung 100 entspricht und deren Bodenfläche bildet. Auf diese Schicht wird eine dielektrische Schicht 2 aufgebracht, auf der je nach Leitungstyp kein, ein oder mehrere Leitungszüge 3 erzeugt werden. Es folgt auf der Gesamtbreite der in Figur 1 auf einem gestrichelten Träger 200 dargestellten Signalleitung eine weitere dielektrische Ummantelung 4, die zusammen mit der Schicht 2 den oder die Leitungszüge vollständig umgibt. Die auf diese Weise hergestellte Struktur wird mit einer Ummantelung 5 versehen, die insgesamt aus Metall besteht oder zumindest auf ihrer Innen- oder Außenseite metallisiert ist und die in elektrisch leitenden Verbindung zu der Schicht 1 steht. Somit erhält man einen vollständig umlaufenden, d.h. in Querschnittsrichtung umlaufenden leitfähigen Mantel. Dieser kann aus Metall bestehen oder metallisiert sein oder aus jedem anderen elektrisch leitenden Material bestehen bzw. damit beschichtet sein.

Die Breite des Dielektrikums nimmt von oben nach unten zu, so dass die Signalleitung 100 im Querschnitt eine flache Glockenform aufweist.

Figur 2 zeigt zwei dieser Signalleitungen 100, 101, die über Kreuz verlaufen als Schnittdarstellung (Figur 2 a)) sowie als perspektivische Darstellung (Figur 2 b)). Die flache Bauform der Signalleitungen 100, 101 ermöglicht diese Ausführung ohne Stützstrukturen. Die Querschnittsgeometrie jeder Signalleitung 100, 101 bleibt im Kreuzungsbereich unverändert, so dass keine Störstellen, d.h. keine Reflexionen im Signalpfad auftreten.

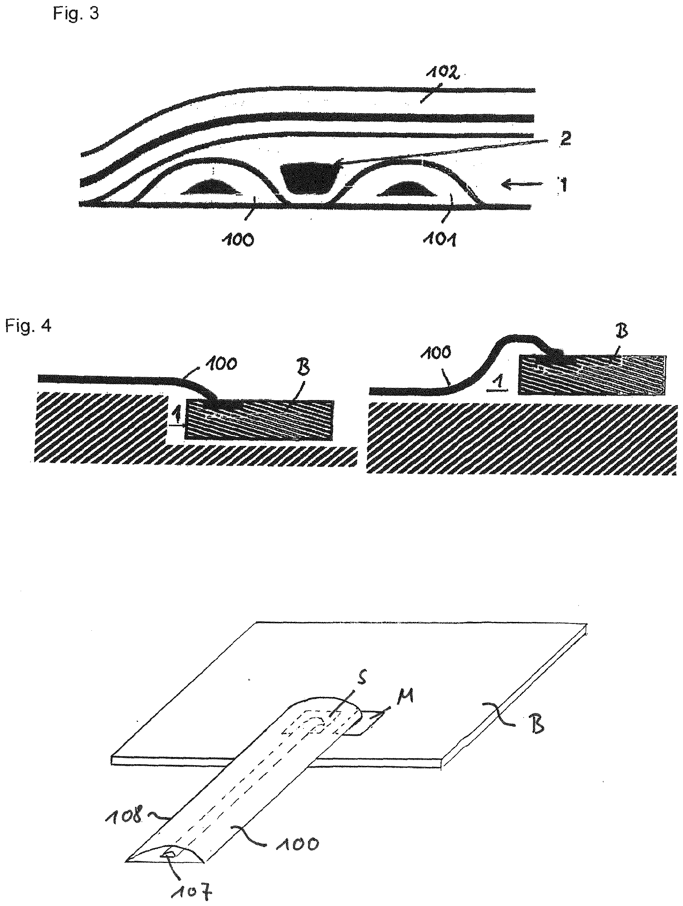

Figur 3 zeigt eine Ausführungsform mit drei Signalleitungen, von denen die oben liegende Signalleitung 102 die beiden unten liegenden Signalleitungen 100, 101 kreuzt.

Mit dem Bezugszeichen 2 ist ein Leiter gekennzeichnet, der sich in Richtung der überdeckten Signalleitungen 100, 101 erstreckt und der eine größere Querschnittsfläche aufweist, als die elektrisch leitfähigen Bestandteile der Signalleitungen. Dieser Leiter 2 kann somit als Leitung mit hoher Stromtragfähigkeit zur Leistungsversorgung etc. verwendet werden.

Das Bezugszeichen 1 kennzeichnet das dielektrische Material, das die Lücken unter der oben liegenden Signalleitung 102 füllt.

Aus Figur 4 ist die Kontaktierung über Bauteilgrenzen hinweg ersichtlich. In Figur 4, linke Darstellung muss ein Spalt zu dem Bauteil B hin überwunden werden. Dieser wird durch ein dielektrisches Material 1 gefüllt. Darauf wird dann eine Signalleitung 100 erzeugt. In Figur 4, rechte Darstellung befindet sich das Bauteil B in einer erhöhten Position, so dass mittels des dielektrischen Materials eine Rampe geschaffen wird, auf der die Signalleitung 100 verlegt wird.

Figur 4, untere Darstellung zeigt die Anbindung der erfindungsgemäß hergestellten Leitung 100 an die Bauteilanschlüsse, wobei der Innenleiter 107 an einen Signalanschluss S geführt wird und der umgebende Außenleiter 108 an einen Masseanschluss M geführt wird und gleichzeitig eine Abschirmung gegen andere Signale erfolgt.

Der gesamte Aufbau (mit oder ohne Träger) gemäß der Figuren 1 bis 4 wird durch ein additives Verfahren gemäß der Erfindung realisiert.

Das gemäß der vorliegenden Erfindung hergestellte System bzw. die Schaltungsanordnung findet vorteilhaft in der Hochfrequenztechnik Anwendung.

Denkbare, aber die Erfindung nicht beschränkende Anwendungen sind:
- Interposer oder space transformer werden dazu verwendet, um Signalleitungen für sehr hohe Datenraten mehrerer ICs oder Anschlussstrukturen unterschiedlicher Abstandsraster mit- einander auf kurzem Wege zu verbinden. Mit dem erfindungsgemäßen Verfahren lassen sich interposer ohne Durchkontaktierungen und Bonddrähte realisieren und somit die größten Störstellen eliminieren, was höhere Datenraten nach sich zieht.
- Für den Test von ICs werden Prüfadapter (device interfaces) benötigt, die alle Anschlüsse des zu testenden Bauteils mit dem Prüfgerät verbinden. Hierzu muss eine Vielzahl von Signalleitungen für hohe Datenraten und/oder hohe Frequenzen mit gleichen Signallaufzeiten von einer sehr kleinen Aufstandsfläche des ICs entflochten werden. Mit dem beschriebenen Verfahren lässt sich dies mit minimalem Übersprechen zwischen den Einzelleitungen und reflexionsarmen Signalpfaden erreichen, was dazu führt, dass Bauteile mit ihrer späteren Anwendungsdatenrate bzw. - frequenz getestet werden können und sehr steile Signalflanken am Prüfling angelegt werden können.
- Mehrere ICs werden zunehmend in packages zusammengefasst, um eine bestimmte Funktionalität bereitzustellen. Zusätzlich werden meist weitere Bauteile wie z.B. Kondensatoren, Widerstände benötigt. Mit dem neuen Verfahren kann eine hohe Integrationsdichte erreicht werden, wobei die Bauteile nicht nur nach elektrischen Gesichtspunkten optimal platziert werden können. Außerdem können ungetestete dies verwendet werden, was die Gesamtkosten des packages wesentlich reduziert.
- Es können MIDs als Träger verwendet werden, so kann z.B. ein radar frontend auf einem Träger aufgebaut werden, der Antennen enthält und mechanisch z.B. als Gehäuse oder Fahrzeug-Stoßstange dient. Auf diesem Träger können ICs aufgebracht werden und anschließend wellenwiderstandsrichtige Verbindungsleitungen zwischen ICs und Antennen aufgebracht werden.
- Schließlich können elektronische Systeme, die in langlebigen Gütern verbaut wurden (Steuergeräte in Kraftfahrzeugen, Heizungsanlagen, Flugzeugen etc.), jederzeit, also auch gegen oder nach Ende des Produktlebenszyklus in bedarfsgerechten Stückzahlen nachgefertigt werden, wodurch Lagerkosten für Ersatzteilhaltung entfallen (Obsoleszenzvermeidung).
- Mit dieser Aufbau- und Verbindungstechnik können herkömmliche Schaltungsträger der Hochfrequenztechnik ersetzt werden, bei welchen mehrere ICs mit Signalleitungen vorgegebenen Leitungswellenwiderstands verbunden werden. Durch die reflexionsarme Verbindung können höhere Datenraten erzielt werden.
- Es können hochintegrierte Funkmodule bestehend aus einem Transceiver und mindestens einer Antenne erzeugt werden, indem Transceiver und Antenne auf kürzestem Wege mit vorgegebenem Leitungswellenwiderstand verbunden werden. Die Antennen können auch dadurch erzeugt werden, dass die Ummantelung der Verbindungsleitungen, ähnlich einem Hornstrahler, aufgeweitet wird, so dass eine möglichst gute Anpassung an den Freiraumwellenwiderstand erfolgt.
- Für optische Verbindungsleitungen zwischen optisch arbeitenden Komponenten können mit dieser Aufbau- und Verbindungstechnik Wellenleiter erzeugt werden, die durch eine metallische Ummantelung des einzelnen Wellenleiters kein Übersprechen untereinander aufweisen.

## Patentansprüche

1. Verfahren zur Herstellung eines elektronischen oder elektrischen Systems, **dadurch gekennzeichnet, dass** das Verfahren das additive Erzeugen, wobei das Erzeugen lagenunabhängig, ohne zweidimensionales Herstellen von Lage für Lage erfolgt, wenigstens einer räumlichen Struktur, die zur Führung elektromagnetischer Wellen ausgebildet ist, unter Verwendung wenigstens einer additiv arbeitenden Vorrichtung umfasst, wobei die additiv arbeitende Vorrichtung mit einem 3D-Druckverfahren arbeitet, wobei das Erzeugen der räumlichen Struktur das sequentielle Auftragen mehrerer Materialien in räumlicher Anordnung zum Aufbau ein oder mehrerer wellenwiderstandsrichtiger Leitungen bzw. Signalleitungen (100, 101) und/oder Wellenleiter umfasst, wodurch das elektronische oder elektrische System teilweise oder vollständig ausgebildet wird, wobei eine wellenwiderstandsrichtige Leitung, insbesondere Signalleitung (100) dadurch hergestellt wird, dass zunächst ein elektrisch leitender Bereich (1) hergestellt oder bereitgestellt wird, auf dieser ein dielektrischer Bereich (2) aufgebracht wird, auf dem wiederum ein oder mehrere Leiterzüge (3) erzeugt werden, ein weiterer dielektrischer Bereich (4) aufgebracht wird, so dass der oder die Leiterzüge (3) von einer dielektrischen Ummantelung (2, 4) umgeben sind und anschließend eine weitere Ummantelung (5) aufgebracht wird, die wenigstens teilweise metallisiert ist oder wird und/oder aus einem Dielektrikum besteht.

2. Verfahren nach Anspruch 1, **dadurch gekennzeichnet, dass** das 3D-Druckverfahren, ein Inkjet-, Aerosol-Jet, Plasmadust- oder ein Extrusionsverfahren oder ein Laserschmelzverfahren ist.

3. Verfahren nach Anspruch 1 oder 2, **dadurch gekennzeichnet, dass** das Verfahren das Auftragen eines oder mehrerer magnetischer und/oder nicht magnetischer Materialien und/oder elektrisch leitender und/oder elektrisch nicht leitender oder sonstiger Materialien und/oder Materialgemische umfasst und/oder dass das elektronische oder elektrische System einen Schaltungsträger umfasst oder aus diesem besteht.

4. Verfahren nach einem der vorhergehenden Ansprüche, **dadurch gekennzeichnet, dass** das Verfahren die Bereitstellung oder Fertigung wenigstens eines Trägers (200) umfasst sowie das Erzeugen der wenigstens einen räumlichen Struktur auf dem Träger (200), wobei der Träger (200) vorzugsweise eine oder mehrere elektrische und/oder mechanische und/oder thermische Funktionalitäten aufweist und/oder der Träger (200) vorzugsweise elektrisch nichtleitend, elektrisch leitend oder hinsichtlich der elektrischen Leitfähigkeit hybrid aufgebaut ist und/oder aus einem Schaltungsträger oder aus einem MID (Molded Interconnected Device) besteht oder diesen/dieses aufweist..

5. Verfahren nach einem der vorhergehenden Ansprüche, **dadurch gekennzeichnet, dass** die wenigstens teilweise metallisierte Ummantelung (5) mit dem elektrisch leitenden Bereich (1) verbunden wird, so dass ein in der Querschnittsansicht vollständig geschlossener leitfähiger Mantel (1, 5) gebildet wird.

6. Verfahren nach einem der vorhergehenden Ansprüche, **dadurch gekennzeichnet, dass** eine wellenwiderstandsrichtige Leitung (100), insbesondere Signalleitung dadurch hergestellt wird, dass ein dielektrischer Bereich (2, 4) hergestellt wird, in dem sich kein oder wenigstens ein Leiterzug (3) befindet, und eine den dielektrischen Bereich umgebende Ummantelung (5) aufgebracht wird, die wenigstens teilweise metallisiert ist oder wird und/oder aus einem Dielektrikum besteht, wobei die vorgenannten Schritte teilweise oder alle gleichzeitig oder nacheinander durchgeführt werden.

7. Verfahren nach einem der vorhergehenden Ansprüche, **dadurch gekennzeichnet, dass** ein oder mehrere der Leiterzüge (3) mit der Ummantelung (5) verbunden werden.

8. Verfahren nach einem der vorhergehenden Ansprüche, **dadurch gekennzeichnet, dass** mehrere Leitungen (100, 101, 102), insbesondere mehrere Signalleitungen über Kreuz verlegt werden, so dass eine Leitung (102) im Kreuzungsbereich über der anderen Leitung (100, 101) liegt, wobei vorzugsweise der Bereich unter der oben liegenden Leitung (102) teilweise durch ein dielektrisches Material aufgefüllt wird und/oder in dem Bereich unter der oben liegenden Leitung ein Raum besteht, der mit einem elektrisch leitfähigen Material und/oder mit einem wärmeleitenden Material ausgefüllt wird.

9. Verfahren nach einem der vorhergehenden Ansprüche, **dadurch gekennzeichnet, dass** Spalte durch ein dielektrisches Material gefüllt werden oder dass mittels des dielektrischen Materials Rampen oder sonstige Erhebungen gebildet werden, um Höhenunterschiede auszugleichen, wobei vorzugsweise vorgesehen ist, dass auf dem dielektrischen Material ein oder mehrere Leitungen (100), insbesondere Signalleitungen verlaufen.

10. Verfahren nach einem der vorhergehenden Ansprüche, **dadurch gekennzeichnet, dass** Leitungen (100), insbesondere Signalleitungen geodätisch zwischen jeweils zwei Punkten erzeugt werden.

11. Verfahren nach einem der vorhergehenden Ansprüche, **dadurch gekennzeichnet, dass** die elektrische und/oder mechanische Integration von Bauteilen (B) jeglicher Art nur durch das additive Verfahren und durch keinen zusätzlichen Prozessschritt erfolgt, insbesondere nicht durch ein Lötverfahren erfolgt, und/oder die mechanische Integration von Bauteilen jeglicher Art durch eine Befestigung an einem Träger (200), durch Einbetten in das dielektrische Material vor dessen Aushärtung, durch das Überdrucken des Bauteils (B) oder durch das Überdecken mit Leitungen (100), insbesondere Signalleitungen erfolgt.

12. Verfahren nach einem der vorhergehenden Ansprüche, **dadurch gekennzeichnet, dass** die elektrische Verbindung einer Leitung (!00), insbesondere einer Signalleitung mit einem Bauteil (B) durch die Kontaktierung der metallischen Ummantelung (108) der Leitung (100) mit dem Gehäuse des Bauteils (B) oder mit einem Masseanschluss (M) des Bauteils (B) und des oder der Leiterzüge (107) mit einem oder mehreren Signalanschlüssen (S) des Bauteils (B) erfolgt, wobei vorzugsweise vorgesehen ist, dass an der Bauteilgrenze impedanzangepasste Übergänge erzeugt werden.

13. Verfahren nach einem der vorhergehenden Ansprüche, **dadurch gekennzeichnet, dass** durch das additive Verfahren und/oder durch ein Sinterverfarhen eine ortsabhängige Leitfähigkeit und/oder Materialeigenschaft, insbesondere ortsabhängige dielektrische Eigenschaften hergestellt werden, die sich vorzugsweise in Längs- und/oder Querrichtung des hergestellten Teils, insbesondere des Leiters ändert.

14. Verfahren nach einem der vorhergehenden Ansprüche, **dadurch gekennzeichnet, dass** genau ein additives Verfahren angewandt wird oder dass mehrere unterschiedliche additive Verfahren eingesetzt werden, die unterschiedliche Auftragsdicken des aufgebrachten Materials erzeugen und/oder dass ein oder mehrere ablative Verfahren eingesetzt werden, und/oder dass das gesamte Verfahren in genau einer Produktionsmaschine erfolgt und/oder dass das Verfahren wenigstens teilweise sequentiell durchgeführt wird und dass während des Verfahrens wenigstens ein Funktionstest an wenigstens einem Element des elektronischen Systems erfolgt und/oder die Verbindung einer Leitung (100) mit einem Bauteil (B) mit denselben Schritten erfolgt wie die Herstellung der Leitung (100) selbst.

15. Elektronisches oder elektrisches System hergestellt nach einem Verfahren gemäß einem der Ansprüche 1 bis 14.

## Claims

1. A method of manufacturing an electronic or electrical system, **characterized in that** the method comprises the additive production, wherein the production takes place layer-independently, without two-dimensional manufacturing layer by layer, of at least one spatial structure that is configured to guide electromagnetic waves using at least one additively working apparatus, wherein the additively working apparatus works with a 3D printing process, wherein the production of the spatial structure comprises the sequential application of a plurality of materials in a spatial arrangement for building up one or more lines of correct characteristic impedance or signal lines (100, 101) and/or waveguides, whereby the electronic or electrical system is partially or completely formed, wherein a line of correct characteristic impedance, in particular a signal line (100), is manufactured **in that** first an electrically conductive region (1) is manufactured or provided, a dielectric region (2) is applied thereon, on which in turn one or more tracks (3) are produced, a further dielectric region (4) is applied so that the track or tracks (3) are surrounded by a dielectric jacket (2, 4), and subsequently a further jacket (5) is applied that is or becomes at least partially metalized and/or consists of a dielectric.

2. The method according to claim 1, **characterized in that** the 3D printing process is an inkjet, aerosol-jet, plasma-dust or an extrusion process or a laser melting process.

3. The method according to claim 1 or 2, **characterized in that** the method comprises the application of one or more magnetic and/or non-magnetic materials and/or electrically conductive and/or electrically non-conductive or other materials and/or material mixtures; and/or **in that** the electronic or electrical system comprises an interconnect device or consists thereof.

4. The method according to any one of the preceding claims, **characterized in that** the method comprises the provision or production of at least one carrier (200) as well as the production of the at least one spatial structure on the carrier (200), wherein the carrier (200) preferably has one or more electrical and/or mechanical and/or thermal functionalities and/or the carrier (200) is preferably configured to be electrically non-conductive, electrically conductive, or hybrid with respect to electrical conductivity and/or consists of an interconnect device or of an MID (Molded Interconnected Device) or comprises the same.

5. The method according to any one of the preceding claims, **characterized in that** the at least partially metalized jacket (5) is connected to the electrically conductive region (1), so that a conductive sheath (1, 5) that is completely closed in cross-sectional view is formed.

6. The method according to any one of the preceding claims, **characterized in that** a line of correct characteristic impedance (100), in particular a signal line, is manufactured **in that** a dielectric region (2, 4) is manufactured in which no track or at least one track (3) is located, and a jacket (5) surrounding the dielectric region is applied that is or becomes at least partially metalized and/or consists of a dielectric, wherein the aforesaid steps are carried out partially or all simultaneously or sequentially.

7. The method according to any one of the preceding claims, **characterized in that** one or more of the tracks (3) are connected to the jacket (5).

8. The method according to any one of the preceding claims, **characterized in that** a plurality of lines (100, 101, 102), in particular a plurality of signal lines, are laid crossed so that one line (102) lies above the other line (100, 101) in the crossing region, wherein preferably the region below the overlying line (102) is partially filled by a dielectric material and/or in the region below the overlying line a space is present that is filled with an electrically conductive material and/or with a thermally conductive material.

9. The method according to any one of the preceding claims, **characterized in that** gaps are filled by a dielectric material or **in that** ramps or other elevations are formed by means of the dielectric material to compensate for height differences, wherein provision is preferably made that one or more lines (100), in particular signal lines, run on the dielectric material.

10. The method according to any one of the preceding claims, **characterized in that** lines (100), in particular signal lines, are geodetically produced between two points in each case.

11. The method according to any one of the preceding claims, **characterized in that** the electrical and/or mechanical integration of components (B) of any kind takes place only by the additive process and not by an additional process step, in particular does not take place by a soldering process, and/or the mechanical integration of components of any kind takes place by a fastening to a carrier (200), by embedding into the dielectric material prior to its curing, by overprinting of the component (B), or by covering with lines (100), in particular signal lines.

12. The method according to any one of the preceding claims, **characterized in that** the electrical connection of a line (100), in particular of a signal line, to a component (B) takes place by contacting of the metallic jacket (108) of the line (100) to a housing of the component (B) or to a ground of the component (B) and of the track or tracks (107) to one or more signal connectors (S) of the component (B), wherein provision is preferably made that impedance-matched transitions are produced at the component boundary.

13. The method according to any one of the preceding claims, **characterized in that** a location-dependent conductivity and/or material property, in particular location-dependent dielectric properties, are produced by the additive process and/or by a sintering process, which preferably changes in the longitudinal and/or transverse direction of the manufactured part, in particular of the conductor.

14. The method according to any one of the preceding claims, **characterized in that** exactly one additive process is used or that a plurality of different additive processes are used that produce different application thicknesses of the applied material and/or that one or more ablative processes are used, and/or in that the entire method takes place in exactly one production machine and/or in that the method is carried out at least partially sequentially and that during the method at least one function test takes place on at least one element of the electronic system and/or the connection of a line (100) to a component (B) takes place with the same steps as the manufacture of the line (100) itself.

15. An electronic or electrical system manufactured by a method according to any one of claims 1 to 14.

## Revendications

1. Procédé de fabrication d'un système électronique ou électrique, **caractérisé en ce que** le procédé comprend la production additive, dans lequel la production a lieu indépendamment des couches, sans fabrication bidimensionnelle couche par couche, d'au moins une structure spatiale qui est configurée pour guider des ondes électromagnétiques en utilisant au moins un appareil travaillant de manière additive, dans lequel l'appareil travaillant de manière additive travaille avec un procédé d'impression 3D, dans lequel la production de la structure spatiale comprend l'application séquentielle de plusieurs matériaux selon un agencement spatial pour la constitution d'une ou plusieurs lignes à impédance caractéristique correcte ou lignes de signal (100, 101) et/ou guides d'ondes, grâce à quoi le système électronique ou électrique est partiellement ou totalement configuré, dans lequel une ligne à impédance caractéristique correcte, en particulier une ligne de signal (100), est fabriquée en ce que d'abord une région électriquement conductrice (1) est fabriquée ou fournie, une région diélectrique (2) est appliquée sur celle-ci, sur laquelle à son tour une ou plusieurs pistes conductrices (3) sont produites, une région diélectrique supplémentaire (4) est appliquée de sorte que la ou les pistes conductrices (3) soient entourées par une enveloppe diélectrique (2, 4), et ensuite une enveloppe supplémentaire (5) est appliquée, qui est ou devient au moins partiellement métallisée et/ou est constituée d'un diélectrique.

2. Procédé selon la revendication 1, **caractérisé en ce que** le procédé d'impression 3D est un procédé à jet d'encre, à jet d'aérosol, à poussière de plasma ou un procédé d'extrusion ou un procédé de fusion laser.

3. Procédé selon la revendication 1 ou 2, **caractérisé en ce que** le procédé comprend l'application d'un ou plusieurs matériaux magnétiques et/ou non magnétiques et/ou de matériaux électriquement conducteurs et/ou électriquement non conducteurs ou d'autres matériaux et/ou mélanges de matériaux ; et/ou **en ce que** le système électronique ou électrique comprend un support de circuit ou est constitué de celui-ci.

4. Procédé selon l'une quelconque des revendications précédentes, **caractérisé en ce que** le procédé comprend la fourniture ou la fabrication d'au moins un support (200) ainsi que la production de l'au moins une structure spatiale sur le support (200), dans lequel le support (200) présente de préférence une ou plusieurs fonctionnalités électriques et/ou mécaniques et/ou thermiques et/ou le support (200) est de préférence configuré pour être électriquement non conducteur, électriquement conducteur ou hybride quant à la conductivité électrique et/ou est constitué d'un support de circuit ou d'un MID (Molded Interconnected Device) ou comprend celui-ci.

5. Procédé selon l'une quelconque des revendications précédentes, **caractérisé en ce que** l'enveloppe (5) au moins partiellement métallisée est reliée à la région électriquement conductrice (1), de sorte qu'une gaine conductrice (1, 5) totalement fermée en vue en coupe transversale soit formée.

6. Procédé selon l'une quelconque des revendications précédentes, **caractérisé en ce qu'**une ligne à impédance caractéristique correcte (100), en particulier une ligne de signal, est fabriquée **en ce qu'**une région diélectrique (2, 4) est fabriquée, dans laquelle ne se trouve aucune ou au moins une piste conductrice (3), et une enveloppe (5) entourant la région diélectrique est appliquée, qui est ou devient au moins partiellement métallisée et/ou est constituée d'un diélectrique, dans lequel les étapes susmentionnées sont réalisées partiellement ou toutes simultanément ou successivement.

7. Procédé selon l'une quelconque des revendications précédentes, **caractérisé en ce qu'**une ou plusieurs des pistes conductrices (3) sont reliées à l'enveloppe (5).

8. Procédé selon l'une quelconque des revendications précédentes, **caractérisé en ce que** plusieurs lignes (100, 101, 102), en particulier plusieurs lignes de signal, sont posées de manière croisée de sorte qu'une ligne (102) se trouve au-dessus de l'autre ligne (100, 101) dans la région de croisement, dans lequel de préférence la région sous la ligne située au-dessus (102) est partiellement remplie par un matériau diélectrique et/ou dans la région sous la ligne située au-dessus se trouve un espace qui est rempli d'un matériau électriquement conducteur et/ou d'un matériau thermiquement conducteur.

9. Procédé selon l'une quelconque des revendications précédentes, **caractérisé en ce que** des fentes sont remplies par un matériau diélectrique ou **en ce qu'**au moyen du matériau diélectrique des rampes ou d'autres élévations sont formées pour compenser des différences de hauteur, dans lequel il est de préférence prévu qu'une ou plusieurs lignes (100), en particulier des lignes de signal, s'étendent sur le matériau diélectrique.

10. Procédé selon l'une quelconque des revendications précédentes, **caractérisé en ce que** des lignes (100), en particulier des lignes de signal, sont produites géodésiquement entre deux points respectifs.

11. Procédé selon l'une quelconque des revendications précédentes, **caractérisé en ce que** l'intégration électrique et/ou mécanique de composants (B) de tout type a lieu uniquement par le procédé additif et par aucune étape de procédé supplémentaire, en particulier n'a pas lieu par un procédé de brasage, et/ou l'intégration mécanique de composants de tout type a lieu par une fixation à un support (200), par enrobage dans le matériau diélectrique avant son durcissement, par la surimpression du composant (B) ou par le recouvrement avec des lignes (100), en particulier des lignes de signal.

12. Procédé selon l'une quelconque des revendications précédentes, **caractérisé en ce que** la connexion électrique d'une ligne (100), en particulier d'une ligne de signal, avec un composant (B) a lieu par la mise en contact de l'enveloppe métallique (108) de la ligne (100) avec le boîtier du composant (B) ou avec une borne de masse (M) du composant (B) et de la ou des pistes conductrices (107) avec une ou plusieurs bornes de signal (S) du composant (B), dans lequel il est de préférence prévu que des transitions adaptées en impédance soient produites à la limite de composant.

13. Procédé selon l'une quelconque des revendications précédentes, **caractérisé en ce que** par le procédé additif et/ou par un procédé de frittage, une conductivité et/ou une propriété de matériau dépendant de l'emplacement, en particulier des propriétés diélectriques dépendant de l'emplacement, sont produites, qui changent de préférence dans la direction longitudinale et/ou transversale de la pièce fabriquée, en particulier du conducteur.

14. Procédé selon l'une quelconque des revendications précédentes, **caractérisé en ce qu'**exactement un procédé additif est utilisé ou que plusieurs procédés additifs différents sont utilisés, qui produisent différentes épaisseurs d'application du matériau appliqué et/ou qu'un ou plusieurs procédés ablatifs sont utilisés, et/ou **en ce que** l'ensemble du procédé a lieu dans exactement une machine de production et/ou **en ce que** le procédé est mis en œuvre au moins partiellement séquentiellement et qu'au cours du procédé au moins un test de fonctionnement a lieu sur au moins un élément du système électronique et/ou la liaison d'une ligne (100) avec un composant (B) a lieu avec les mêmes étapes que la fabrication de la ligne (100) elle-même.

15. Système électronique ou électrique fabriqué selon un procédé selon l'une quelconque des revendications 1 à 14.
